Europäisches Patentamt

(19) European Patent Office

Office européen des brevets

(11) Numéro de publication: **0 372 608**

**A1**

## (12) DEMANDE DE BREVET EUROPEEN

(21) Numéro de dépôt: **89202941.4**

(22) Date de dépôt: **20.11.89**

(51) Int. Cl.⁵: **H04N 7/13, G06F 15/76**

(30) Priorité: **25.11.88 FR 8815427**

(43) Date de publication de la demande:
**13.06.90 Bulletin 90/24**

(84) Etats contractants désignés:
**DE FR GB SE**

(71) Demandeur: **LABORATOIRES
D'ELECTRONIQUE PHILIPS
3, Avenue Descartes
F-94450 Limeil-Brévannes(FR)**
㉘ **FR**

Demandeur: **N.V. Philips'
Gloeilampenfabrieken
Groenewoudseweg 1
NL-5621 BA Eindhoven(NL)**
㉘ **DE GB SE**

(72) Inventeur: **Naillon, Martine
SOCIETE CIVILE S.P.I.D. 209, rue de
l'Université
F-75007 Paris(FR)**
Inventeur: **Theeten, Jean-Bernard
SOCIETE CIVILE S.P.I.D. 209, rue de
l'Université
F-75007 Paris(FR)**

(74) Mandataire: **Landousy, Christian et al
Société Civile S.P.I.D. 209, Rue de
l'Université
F-75007 Paris(FR)**

(54) **Procédé et dispositif de compression de données d'image utilisant un réseau de neurones.**

㉗ Procédé et dispositif de compression de données d'images par quantification vectorielle selon un précodage par blocs, puis comparaison par un réseau de neurones des blocs précodés avec des mots de référence stockés sous forme d'un dictionnaire afin de transmettre à un récepteur des index sélectionnés. Selon le procédé, le réseau de neurones effectue un apprentissage avec des prototypes prescrits puis à l'aide de vecteurs test issus de l'image génère un dictionnaire adaptatif qui est transmis au récepteur. Cette adaptation utilise des attracteurs, qui peuvent être des états métastables induits, du réseau de neurones, et qui subissent une procédure d'optimisation.

Le dispositif peut traiter des images en vue de leur stockage. Il est également possible d'utiliser deux dispositifs qui opèrent alternativement l'un pour générer le dictionnaire adaptatif et l'autre pour l'utiliser afin de traiter en temps réel des images de type télévision.

Application : Traitement d'images.

FIG.6

## PROCEDE ET DISPOSITIF DE COMPRESSION DE DONNEES D'IMAGE UTILISANT UN RESEAU DE NEURONES.

L'invention concerne un procédé et un dispositif de compression de données d'images par quantification vectorielle selon un pré-codage par blocs formés de plusieurs éléments d'image, puis comparaison par un réseau de neurones des blocs pré-codés avec des mots de référence stockés sous forme d'un dictionnaire dans le réseau de neurones afin de transmettre à un récepteur des index sélectionnés correspondant aux index des mots de référence les plus proches des blocs précodés.

L'invention concerne également une structure pour la compression de données d'images mettant en oeuvre plusieurs de ces dispositifs.

Un dispositif de compression de données de ce genre est connu du document "Building a hierarchy with neural networks :

an example - image vector quantization"

L.D. JACKEL, R.E. HOWARD, J.S. DENKER, W. HUBBARD and S.A. SOLLA.

Applied Optics vol 26 n° 23 December 1987 page 5081.

Ce document décrit l'utilisation d'un réseau de neurones qui effectue le codage de données d'images par quantification vectorielle. Il concerne des images de télévision de haute définition en vue d'effectuer leur transmission numérique en temps réel. Compte-tenu de la limitation des canaux de transmission, il est nécessaire d'opérer une compression des données. Pour cela une image est pré-codée en blocs formés chacun de plusieurs éléments d'image (pixel en langue anglaise). Pour limiter la quantité de données à transmettre, on compare chaque bloc à une liste de mots de référence (se rapportant à des blocs de référence) placée dans un dictionnaire (Codebook en langue anglaise) et sur un critère de similitude, on sélectionne un mot de référence du dictionnaire approchant le plus le bloc à coder et l'on transmet uniquement son index permettant ainsi de le retrouver dans la liste du même dictionnaire placé à la réception.

Selon ce document, cette opération de reconnaissance est effectuée à l'aide d'un réseau de neurones afin de pouvoir opérer à la cadence nécessaire au codage d'une image vidéo. Ce document met en oeuvre un dictionnaire fixe qui est pré-établi. Il ne peut donc pas s'adapter à des configurations d'images multiples.

Le problème posé est d'améliorer la qualité du dictionnaire afin de pouvoir coder efficacement la quasi-totalité des configurations d'images à traiter, et d'assurer une grande qualité intrinsèque de restitution des images.

La solution à ce problème consiste en un procédé qui comprend une phase de génération d'un dictionnaire adaptatif par le réseau de neurones, cette phase comprenant les étapes suivantes :

A - Introduction dans le réseau de neurones de prototypes prescrivant des états de neurones stables au réseau de neurones qui détermine ses coefficients synaptiques associés à chaque prototype au cours de phases d'apprentissage,

B - Résolution par le réseau de neurones à l'aide de vecteurs test issus de l'image en opérant selon des phases dynamiques de relaxation successives mises en oeuvre en bouclant l'entrée et la sortie du réseau de neurones à l'issue desquelles les états de neurones se stabilisent sur des configurations appelées attracteurs autour desquels se regroupent en nuage les vecteurs test,

C - Comparaison de chaque vecteur test avec son attracteur correspondant, avec détermination de la distance qui les sépare l'un de l'autre et détermination du taux de fréquentation de chaque attracteur par les vecteurs test,

D - Détermination de la moyenne globale de toutes les distances :

. et lorsque cette moyenne globale est supérieure à une valeur prédéterminée, sélection des attracteurs dont le taux de fréquentation est supérieur à un taux prédéterminé, puis détermination du centre de gravité de l'ensemble du nuage existant autour de chaque attracteur sélectionné pour générer un attracteur optimal lorsqu'il est meilleur et conserver l'ancien dans le cas inverse afin de former un lot de nouveaux attracteurs qui sont recyclés comme nouveaux prototypes pour reprendre à nouveau le procédé à l'étape A,

. et lorsque cette moyenne globale est inférieure à la valeur prédéterminée, utilisation de tous les attracteurs finals, pour constituer les mots de référence du dictionnaire adaptatif qui sont mémorisés dans une mémoire de coefficients synaptiques du réseau de neurones, lesdits mots de référence étant transmis au récepteur pour mettre à jour son dictionnaire local, le procédé comprenant ensuite une phase de codage utilisant lesdits mots de référence pour coder l'image globale puis sélectionner les index à transmettre.

Ce procédé peut être mis en oeuvre à l'aide d'un calculateur programmé.

La solution consiste également en un dispositif qui, pour mettre en oeuvre le procédé, comprend :

- un réseau de neurones muni de moyens d'apprentissage,

- une mémoire pour stocker des vecteurs test issus de l'image,
- une mémoire pour stocker des prototypes prescrivant des états stables au réseau de neurones,
lesdites deux mémoires délivrant leurs données au réseau de neurones qui, pour chaque prototype prescrit, détermine ses coefficients synaptiques correspondants au cours de phases d'apprentissage, puis effectue des phases de résolution avec les vecteurs test en opérant selon une dynamique de relaxation à l'issue desquelles les états de neurones se stabilisent sur des configurations appelées attracteurs autour desquels se regroupent en nuage les vecteurs test, le réseau de neurones étant pour cela bouclé sur lui-même,
- et un circuit adaptatif
. qui compare chaque vecteur test avec son attracteur correspondant,
. qui détermine la distance qui les sépare l'un de l'autre,
. qui détermine le taux de fréquentation de chaque attracteur par les vecteurs test,
. qui détermine la moyenne globale de toutes les distances,

   i) et lorsque cette moyenne globale est supérieure à une valeur prédéterminée, sélectionne les attracteurs dont le taux de fréquentation est supérieur à un taux prédéterminé puis qui détermine le centre de gravité de l'ensemble du nuage existant autour de chaque attracteur sélectionné pour générer un attracteur recentré lorsqu'il est meilleur et conserver l'ancien dans le cas inverse afin de former un lot de nouveaux attracteurs qui sont utilisés comme nouveaux prototypes prescrits dans le réseau de neurones pour opérer au moins un nouveau cycle d'adaptation,

   ii) et lorsque cette moyenne globale de toutes les distances est inférieure à la valeur prédéterminée, le dispositif utilise tous les attracteurs finals pour constituer les mots de référence du dictionnaire adaptatif :
. qui sont mémorisés dans la mémoire de coefficients synaptiques,
. qui sont utilisés pour le codage de l'image globale,
. qui sont stockés dans une mémoire d'attracteurs pour être utilisés par un circuit d'indexage pour sélectionner les index à transmettre,
. qui sont transmis au récepteur pour la mise à jour du dictionnaire local.

Il est aussi possible de réaliser une structure pour la compression de données d'image qui comprend deux dispositifs de compression d'images afin de traiter en temps réel des images de type télévision, la structure comprenant en outre un compteur de séquences d'images qui au cours d'une séquence donnée met un des dispositifs dans la phase de génération du dictionnaire adaptatif, tandis que l'autre dispositif est mis dans la phase de codage de l'image globale, puis inversement au cours de la séquence suivante.

L'invention utilise un réseau de neurones selon des étapes de résolution et d'apprentissage. Un réseau de neurones est un ensemble d'automates élémentaires qui déterminent l'état $V_i$ à l'instant $t+1$ d'un neurone de sortie i à partir des états $V_j$, à l'instant t, des neurones d'entrée j qui lui sont connectés selon des synapses par des coefficients synaptiques $C_{ij}$ tel que :

$$V_i(t+1) = F(\sum_{j=1}^{N} C_{ij} \cdot V_j(t)) \qquad (1)$$

où F est une fonction non linéaire.

Le document de l'art antérieur cité ne met en oeuvre que des étapes de résolution qui consistent à déterminer les états $V_i$ de tous les neurones de sortie selon l'expression précédente.

L'invention met en oeuvre en outre des étapes d'apprentissage qui consistent à adapter les coefficients synaptiques $C_{ij}$ au codage à effectuer. Le réseau de neurones est mis dans une dynamique de relaxation pour qu'il converge vers des configurations stables d'états de neurones. Pour cela il est bouclé sur lui-même, ses neurones de sortie devenant ses neurones d'entrée. Le réseau de neurones converge automatiquement vers des configurations stables. Certaines sont choisies comme prototypes utilisés lors de la génération du dictionnaire. Au départ, on prescrit les prototypes (données d'entrée) en déterminant les coefficients synaptiques appropriés. On présente ensuite au réseau de neurones des vecteurs test qui sont des blocs sélectionnés de façon aléatoire dans toute l'image à coder. Quand on présente un vecteur test (états de neurones d'entrée) au réseau de neurones, celui-ci évolue vers un état stable qui prend le nom d'attracteur (états de neurones de sortie). Il apparaît en outre que le réseau de neurones peut se stabiliser sur des états non prescrits appelés dans l'invention métastables induits. Ceux-ci peuvent également être sélectionnés pour constituer des attracteurs. Le terme "métastable" se rapporte au degré de stabilité de l'attracteur et le terme "induit" se rapporte au mécanisme de génération d'attracteurs secondaires découlant de la prescription des prototypes. Ainsi les attracteurs peuvent comprendre des états métastables induits sur lesquels se stabilise le réseau de neurones. Plusieurs vecteurs test vont ainsi se regrouper en nuage autour de chaque attracteur. Un nuage va se caractériser par l'attracteur qui lui donne naissance, par le nombre de vecteurs test du nuage et par la distance qui sépare chaque vecteur test de l'attracteur.

Un premier aspect à analyser concerne cette distance. Pour cela lorsque tous les vecteurs test ont été utilisés, on effectue une moyenne globale de toutes les distances. Lorsque la moyenne globale est inférieure à une valeur prédéterminée les attracteurs sont satisfaisants et peuvent être utilisés comme mots de référence du dictionnaire.

Lorsque la moyenne globale est supérieure à la valeur prédéterminée, les attracteurs ne sont pas satisfaisants et il est nécessaire de mettre en oeuvre à nouveau au moins un cycle complet du procédé. Pour cela on considère un deuxième aspect relatif à la fréquentation de chaque attracteur par les vecteurs test et on détermine les taux de fréquentation puis on sélectionne un certain nombre d'attracteurs dont le taux de fréquentation est supérieur à un taux prédéterminé. L'ensemble de tous les attracteurs est néanmoins stocké dans une mémoire d'attracteurs. Puis on détermine le centre de gravité pour chaque nuage entourant ces attracteurs sélectionnés. En effet pour un nuage donné, l'attracteur qui lui a donné naissance n'est pas obligatoirement l'attracteur optimal. La détermination du centre de gravité du nuage permet ainsi de substituer à l'ancien attracteur, si cela est nécessaire, un attracteur optimal correspondant mieux à la configuration de ce nuage.

Les attracteurs sélectionnés qui ont essentiellement été optimisés sont réintroduits au début d'un cycle suivant du procédé en tant que prototypes prescrits. Pour chaque prototype prescrit, le réseau de neurones, à l'aide d'une phase d'apprentissage, détermine à chaque fois les coefficients synaptiques correspondants. Le procédé peut ainsi se répéter sur plusieurs cycles jusqu'à ce que la moyenne globale des distances soit inférieure à une valeur prédéterminée indiquant que les attracteurs finals obtenus sont satisfaisants. L'ensemble de la population des attracteurs finals, qui est ainsi stockée dans le réseau de neurones à l'issue de cette phase d'apprentissage, constitue alors les mots de référence du dictionnaire qui est utilisé par un circuit d'indexage pour traiter l'ensemble de l'image. Le même réseau de neurones est ainsi utilisé d'abord pour générer puis pour utiliser le dictionnaire adaptatif.

Le procédé peut concerner le codage d'images en vue de leur stockage dans des organes appropriés. Mais préférentiellement il concerne le codage d'images de télévision de haute définition en vue d'effectuer leur transmission numérique en temps réel. Pour cela on utilise deux dispositifs qui opèrent alternativement l'une et l'autre fonction. Ainsi l'adaptativité peut être très rapide et permettre une très grande qualité de restitution de l'image. Ainsi également selon l'invention le procédé génère un dictionnaire adaptatif au cours de phases d'apprentissage et d'adaptation à l'aide d'un premier réseau de neurones et simultanément utilise le dictionnaire adaptatif généré à la période de temps précédente dans un second réseau de neurones. L'invention sera mieux comprise à l'aide des figures suivantes, données à titre d'exemple non limitatif, qui représentent :

Figures 1A, 1B : un schéma du mode de pré-codage d'une image à traiter,

Figure 2 : un schéma des organes essentiels d'un réseau de neurones,

Figure 3 : une représentation de deux nuages de vecteurs test autour de deux attracteurs,

Figure 4 : un schéma d'un dispositif de compression de données d'image selon l'invention pour coder des images à stocker,

Figure 5 : un schéma du circuit de comparaison,

Figure 6 : un schéma d'un dispositif de compression de données d'image selon l'invention pour coder des images de type télévision en temps réel,

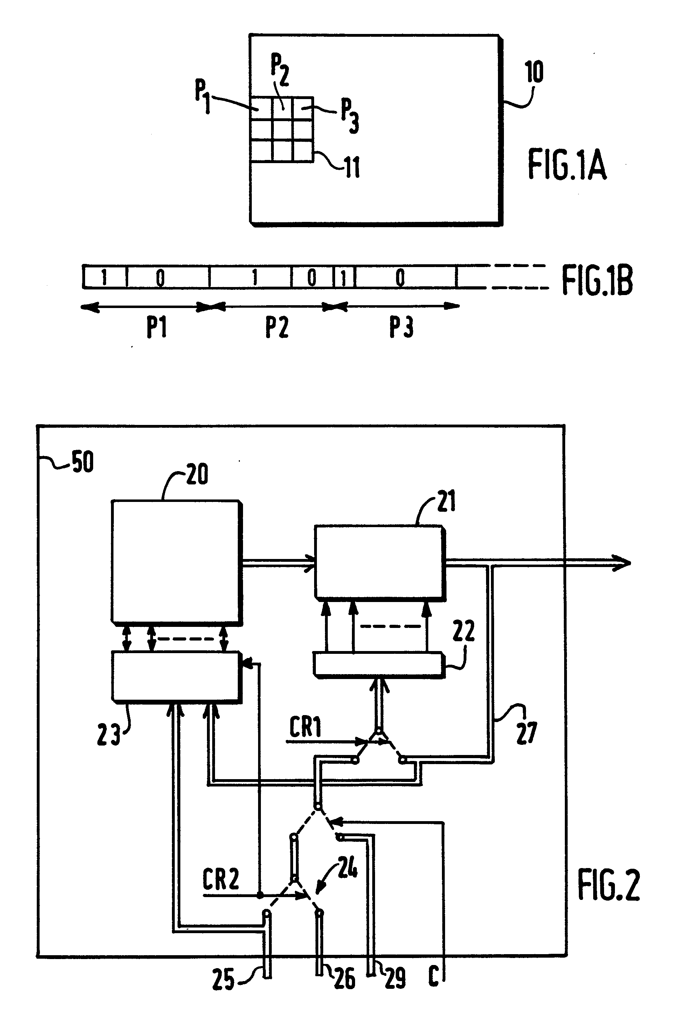

La figure 1a représente une image 10 dans laquelle est isolé un bloc 11, lui-même formé de plusieurs éléments d'images tels que P1, P2, P3. Pour le pré-codage de l'image toute l'image est ainsi découpée selon de tels blocs. Les niveaux de luminance des éléments d'image vont être codés par exemple sur 8 bits soit 256 niveaux. Ceux-ci peuvent être représentés selon un codage thermométrique indiqué sur la figure 1B c'est-à-dire que dans une graduation de 1 à 256 le niveau à coder sera représenté par des 1 jusqu'à la valeur de ces niveaux puis par la valeur opposée (par exemple -1 ou 0 selon le précodage utilisé) au-dessus de cette valeur. Un bloc est codé en formant un vecteur constitué du codage de tous les éléments d'image qui le compose. Les vecteurs test, les prototypes et les états de neurones sont codés selon cette représentation.

La figure 2 représente un schéma des organes essentiels d'un réseau de neurones 50. Il comprend une mémoire de coefficients synaptiques 20 qui délivre ses données à un organe de calcul 21 qui reçoit des états de neurones d'entrée stockés dans une mémoire d'états 22. L'organe de calcul 21 effectue les calculs de l'équation 1 en déterminant les états de neurones de sortie $V_i(t+1)$. Les états de sortie ainsi déterminés sont réintroduits en entrée lorsque le réseau de neurones est en phase de résolution avec les vecteurs test pour opérer selon une dynamique de relaxation au cours de laquelle le réseau de neurones se stabilise sur des états de sortie déterminés appelés attracteurs (signal de commande CR1). Selon l'exemple d'algorithme d'apprentissage décrit ci-après, à chaque cycle du procédé on introduit des prototypes prescrits dans la mémoire 22 et on utilise les états de sortie de l'organe de calcul 21 sans l'application de la fonction non linéaire F dans des moyens d'apprentissage 23 par exemple un calculateur hôte. Celui-ci détermine des nouveaux coefficients synaptiques $C_{ij}$ en les corrigeant selon un algorithme connu d'apprentissage.

Un tel algorithme est par exemple l'algorithme du recouvrement minimal décrit dans le document "Learning algorithms with optimal stability in neural networks" W. KRAUTH et M. MEZARD J. Phys. A : Math. Gen. 20 (1987) page 745.

Pour tous les prototypes prescrits, de composantes $PR_i$, pour un indice i donné (c'est-à-dire pour une ligne de la matrice $C_{ij}$) on calcule (avec N nombre de neurones) :

$$S_i^{(t+1)} = \sum_{j=1}^{N} C_{ij}.PR_j$$

puis on calcule également le produit $PR_i.S_i$ pour chaque prototype prescrit. On détermine ensuite la valeur minimale $(PR_i.S_i)_{min}$ que présentent ces produits. On compare cette valeur minimale à une valeur prédéterminée.

- Lorsque $(PR_i.S_i)_{min}$ est inférieur à la valeur prédéterminée, on opère la remise à jour de la ligne de coefficients synaptiques $C_{ij}$ ayant l'indice i donné tel que:

$C_{ij}$(nouveau) = $C_{ij}$(ancien) + (1/N) $PR_i.PR_j$

où $PR_i$ et $PR_j$ se rapportent au prototype prescrit qui a donné la valeur minimale $(PR_i.S_i)_{min}$.

- Lorsque $(PR_i.S_i)_{min}$ est supérieur à la valeur prédéterminée, les coefficients synaptiques $C_{ij}$, pour l'indice i donné, sont satisfaisants.

On passe alors à l'indice i suivant et on recommence la même procédure. Cet algorithme est mis en oeuvre dans les moyens d'apprentissage 23.

Un sélecteur 24 permet de charger la mémoire 22 soit avec les prototypes prescrits (connexion 25) en phase d'apprentissage, soit par les vecteurs test (connexion 26). Le signal de commande CR1 permet de mettre le réseau de neurones dans une dynamique de relaxation en le bouclant sur lui-même. Le signal de commande C permet de sélectionner soit le mode de génération du dictionnaire soit le mode d'utilisation du dictionnaire pour coder l'image globale dont les données entrent par la connexion 29.

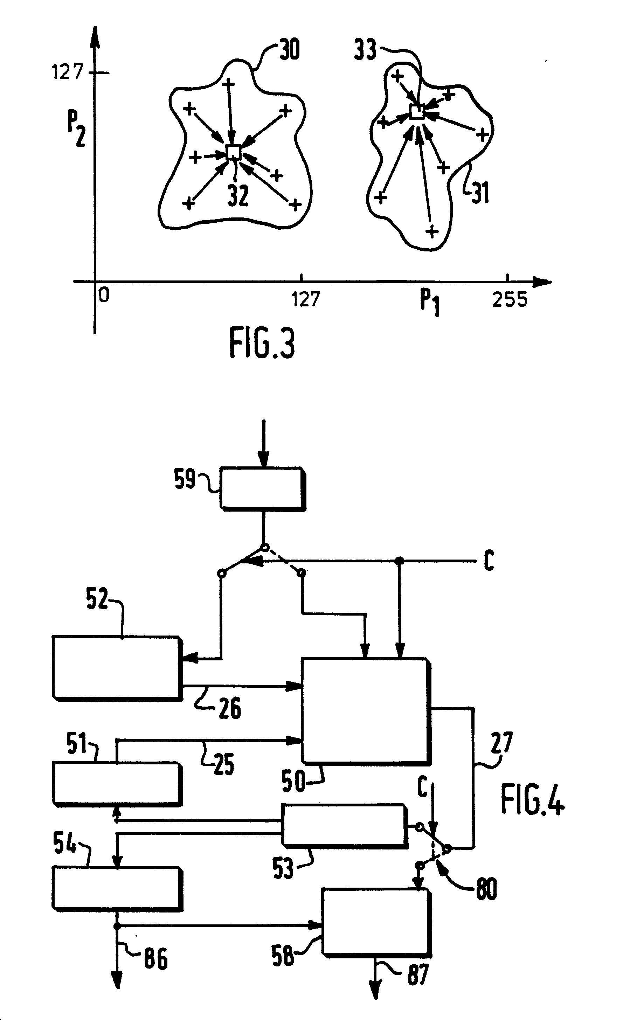

La figure 3 est une représentation très simplifiée de deux nuages 30, 31 de vecteurs test autour de respectivement deux attracteurs 32, 33 dans un exemple simple à deux éléments d'image, ce qui permet une représentation dans un plan. Dans un cas réel à n éléments d'image, l'espace est à n dimensions. Le nuage se caractérise par son nombre de vecteurs test (donc le taux de fréquentation de l'attracteur) et par la distance qui sépare chaque vecteur test de son attracteur. Dans un premier temps on détermine la distance moyenne globale. Deux cas se présentent :

- lorsque cette distance est inférieure à une valeur prédéterminée la population des attracteurs est satisfaisante et peut être utilisée pour générer le dictionnaire adaptatif.

- lorsque cette distance est supérieure à une valeur prédéterminée la population des attracteurs n'est pas satisfaisante et il faut recommencer un cycle du procédé en modifiant le lot des prototypes prescrits. Pour cela les attracteurs les plus fréquentés sont sélectionnés et pour chacun des nuages qui les concerne on repositionne l'attracteur en calculant le centre de gravité du nuage qui devient l'attracteur optimal. Pour opérer au cours des cycles suivants du procédé, on introduit en entrée un nombre limité de prototypes prescrits qui sont choisis pour leur taux de fréquentation parmi les attracteurs optimaux corrigés éventuellement après recentrage qui peuvent eux-mêmes être issus soit de prototypes prescrits au cycle précédent soit d'états métastables induits.

A titre d'exemple très simplifié soit, au début du premier cycle, cinq prototypes prescrits PR1, PR2, PR3, PR4 et PR5. A la fin du premier cycle, on peut avoir la situation suivante :

LISTE 1...........transformée en.................. LISTE 2

```
┌─────┐                                          ┌─────┐
│ PR1 │ .................inchangé................ │ PR1 │
│ PR2 │ ..après recentrage devient l'attracteur..│ AT1 │
│ PR3 │ .........pas sélectionné................. │  /  │
│ PR4 │ .............inchangé.................... │ PR4 │
│ PR5 │ ..après recentrage devient l'attracteur..│ AT2 │
│  /  │ .....état métastable induit sélectionné..│ ME1 │
└─────┘                                          └─────┘
```

Au cours du deuxième cycle, la liste 2 est utilisée pour constituer les nouveaux prototypes prescrits. Le mécanisme est renouvelé sur plusieurs cycles jusqu'à ce que la moyenne globale des distances devienne inférieure à la valeur prédéterminée. L'ensemble de tous les attracteurs finals qui ont été stockés dans la mémoire d'attracteurs sont alors utilisés pour constituer les mots de référence du dictionnaire adaptatif.

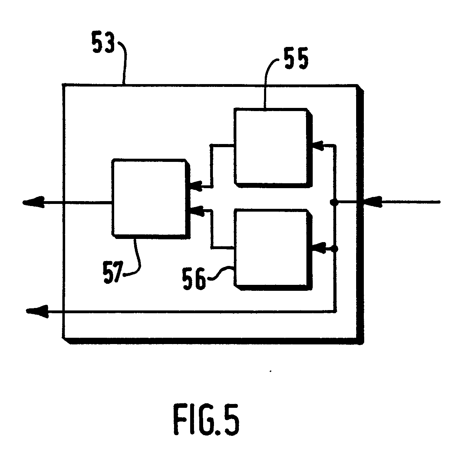

Sur la figure 4 est représenté un dispositif de compression de données d'image selon l'invention. Il comprend le réseau de neurones 50 décrit précédemment réuni à une mémoire de prototypes 51 et à une mémoire de vecteurs test 52 qui effectue également la sélection des vecteurs test issus de l'image. Les états de neurones de sortie $V_i$ (connexion 27) entrent dans un circuit d'adaptation 53 qui fournit tous les attracteurs à la mémoire d'attracteurs 54. La mémoire de prototypes 51 reçoit les attracteurs qui ont été sélectionnés pour constituer les nouveaux prototypes. Le circuit d'adaptation 53 représenté sur la figure 5 comprend :
- un compteur 55 pour déterminer les taux de fréquentation,
- un moyen de calcul 56 pour faire la moyenne globale de toutes les distances et calculer les centres de gravité des nuages,
- un comparateur 57 pour comparer :
. les taux de fréquentation à un taux prédéterminé,
. la moyenne globale à une valeur prédéterminée.

Les images sont organisées en blocs de plusieurs éléments d'image codés en niveaux de luminance par exemple en notation thermométrique par un pré-codeur 59 (fig. 4). Les attracteurs sont lus dans la mémoire d'attracteurs 54 et introduits dans un circuit d'indexage 58 qui détermine les index de l'image codée par le réseau de neurones 50 commutée sur le circuit d'indexage 58 à l'aide du commutateur 80. Les index sont transmis (connexion 87) au récepteur qui reçoit également (connexion 86) de temps en temps une remise à jour du dictionnaire adaptatif.

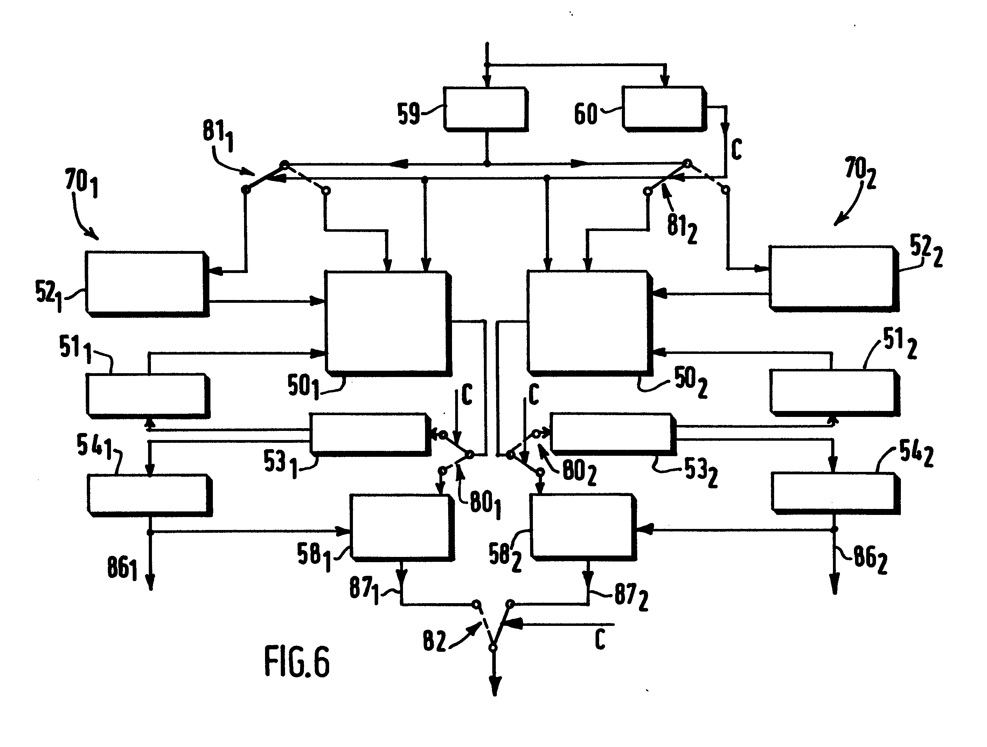

La figure 6 représente un schéma d'une structure de compression de données d'image selon l'invention pour coder des images de type télévision en temps réel. Elle comprend deux dispositifs $70_1$, $70_2$ tels que décrits sur la figure 4 chacun ayant :
. un circuit de neurones $50_1$, $50_2$
. une mémoire de prototypes $51_1$, $51_2$
. une mémoire de vecteurs de test $52_1$, $52_2$
. une mémoire d'attracteurs $54_1$, $54_2$
. un circuit d'adaptation $53_1$ $53_2$
. un circuit d'indexage $58_1$, $58_2$

Les deux dispositifs opèrent simultanément l'un pour générer un dictionnaire adaptatif et l'autre pour utiliser le dictionnaire généré lors de la séquence précédente. Pour cela un compteur de séquences d'images 60 génère un signal de commande C qui opère alternativement sur l'un ou l'autre circuit (commutateurs $80_1$, $80_2$, $81_1$, $81_2$, 82). Sur un cycle, un dispositif effectue successivement des phases d'apprentissage et d'adaptation. Simultanément l'autre dispositif effectue des phases successives de résolution en utilisant le dictionnaire généré à la séquence précédente. Le processus s'inverse à la séquence suivante. Les index sont transmis par les connexions $87_1$, $87_2$ et les mises à jour des dictionnaires sont effectuées par les connexions $86_1$, $86_2$.

**Revendications**

1. Procédé pour un dispositif de compression de données d'images par quantification vectorielle selon un pré-codage par blocs formés de plusieurs éléments d'image, puis comparaison par un réseau de neurones des blocs pré-codés avec des mots de référence stockés sous forme d'un dictionnaire dans le réseau de neurones afin de transmettre à un récepteur des index sélectionnés correspondant aux index des mots de référence les plus proches des blocs précodés, caractérisé en ce qu'il comprend une phase de génération d'un dictionnaire adaptatif par le réseau de neurones, cette phase comprenant les étapes suivantes:

A - Introduction dans le réseau de neurones de prototypes prescrivant des états de neurones stables au réseau de neurones qui détermine ses coefficients synaptiques associés à chaque prototype au cours de phases d'apprentissage,

B - Résolution par le réseau de neurones à l'aide de vecteurs test issus de l'image en opérant selon des phases dynamiques de relaxation successives mises en oeuvre en bouclant l'entrée et la sortie du réseau de neurones à l'issue desquelles les états de neurones se stabilisent sur des configurations appelées attracteurs autour desquels se regroupent en nuage les vecteurs test,

C - Comparaison de chaque vecteur test avec son attracteur correspondant, avec détermination de la distance qui les sépare l'un de l'autre et détermination du taux de fréquentation de chaque attracteur par les vecteurs test,

D - Détermination de la moyenne globale de toutes les distances :

. et lorsque cette moyenne globale est supérieure à une valeur prédéterminée, sélection des attracteurs dont le taux de fréquentation est supérieur à un taux prédéterminé, puis détermination du centre de gravité de l'ensemble du nuage existant autour de chaque attracteur sélectionné pour générer un attracteur optimal lorsqu'il est meilleur et conserver l'ancien dans le cas inverse afin de former un lot de nouveaux attracteurs qui sont recyclés comme nouveaux prototypes pour reprendre à nouveau le procédé à l'étape A,

. et lorsque cette moyenne globale est inférieure à la valeur prédéterminée, utilisation de tous les attracteurs finals, pour constituer les mots de référence du dictionnaire adaptatif qui sont mémorisés dans une mémoire de coefficients synaptiques du réseau de neurones, lesdits mots de référence étant transmis au récepteur pour mettre à jour son dictionnaire local,

le procédé comprenant ensuite une phase de codage utilisant lesdits mots de référence pour coder l'image globale puis sélectionner les index à transmettre.

2. Procédé selon la revendication 1 caractérisé en ce que pour effectuer la comparaison, les prototypes, les vecteurs test et les états de neurones sont codés en notation thermométrique.

3. Procédé selon une des revendications 1 ou 2 caractérisé en ce que les attracteurs comprennent des états métastables induits sur lesquels se stabilise le réseau de neurones.

4. Procédé selon une des revendications 1 à 3 caractérisé en ce que sur une période de temps donnée, le procédé génère un dictionnaire adaptatif au cours de phases d'apprentissage et d'adaptation à l'aide d'un premier réseau de neurones et simultanément utilise le dictionnaire adaptatif généré à la période de temps précédente dans un second réseau de neurones.

5. Dispositif pour la compression de données d'image par quantification vectorielle selon un pré-codage d'une image par blocs formés de plusieurs éléments d'image, puis comparaison par un réseau de neurones des blocs pré-codés avec des mots de référence mémorisés sous forme d'un dictionnaire dans un réseau de neurones afin de délivrer des index sélectionnés correspondant aux index des mots de référence les plus proches des blocs précodés, le réseau de neurones ayant une mémoire de coefficients synaptiques et un organe de calcul, caractérisé en ce que le dispositif comprend :

- un réseau de neurones muni de moyens d'apprentissage,
- une mémoire pour stocker des vecteurs test issus de l'image,
- une mémoire pour stocker des prototypes prescrivant des états stables au réseau de neurones,

lesdites deux mémoires délivrant leurs données au réseau de neurones qui, pour chaque prototype prescrit, détermine ses coefficients synaptiques correspondants au cours de phases d'apprentissage, puis effectue des phases de résolution avec les vecteurs test en opérant selon une dynamique de relaxation à l'issue desquelles les états de neurones se stabilisent sur des configurations appelées attracteurs autour desquels se regroupent en nuage les vecteurs test, le réseau de neurones étant pour cela bouclé sur lui-même,

- et un circuit adaptatif

. qui compare chaque vecteur test avec son attracteur correspondant,
. qui détermine la distance qui les sépare l'un de l'autre,
. qui détermine le taux de fréquentation de chaque attracteur par les vecteurs test,
. qui détermine la moyenne globale de toutes les distances,

i) et lorsque cette moyenne globale est supérieure à une valeur prédéterminée, qui sélectionne les attracteurs dont le taux de fréquentation est supérieur à un taux prédéterminé puis qui détermine le centre de gravité de l'ensemble du nuage existant autour de chaque attracteur sélectionné pour générer un attracteur recentré lorsqu'il est meilleur et conserver l'ancien dans le cas inverse afin de former un lot de nouveaux attracteurs qui sont utilisés comme nouveaux prototypes prescrits dans le réseau de neurones pour opérer au moins un nouveau cycle d'adaptation,

ii) et lorsque cette moyenne globale de toutes les distances est inférieure à la valeur prédéterminée, le dispositif utilise tous les attracteurs finals pour constituer les mots de référence du dictionnaire adaptatif :
. qui sont mémorisés dans la mémoire de coefficients synaptiques,
. qui sont utilisés pour le codage de l'image globale,
. qui sont stockés dans une mémoire d'attracteurs pour être utilisés par un circuit d'indexage pour sélectionner les index à transmettre,
. qui sont transmis au récepteur pour la mise à jour du dictionnaire local.

6. Structure pour la compression de données d'image caractérisée en ce qu'elle comprend deux dispositifs de compression d'image selon la revendication 5 afin de traiter en temps réel des images de type télévision, la structure comprenant en outre un compteur de séquence d'images qui au cours d'une séquence donnée met un des dispositifs dans la phase de génération du dictionnaire adaptatif, tandis que l'autre dispositif est mis dans la phase de codage de l'image globale, puis inversement au cours de la séquence suivante.

EP 0 372 608 A1

FIG.1A

FIG.1B

FIG.2

EP 0 372 608 A1

FIG.3

FIG.4

2-IV-PHF 88-626

FIG.5

FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,A | APPLIED OPTICS, vol. 26, no. 23, 1 décembre 1987, pages 5081-5084, Optical Society of America, New York, US; L.D. JACKEL et al.: "Building a hierarchy with neural networks: an example - image vector quantization" * Page 5082, colonne de gauche, ligne 47 - page 5084, colonne de droite, ligne 15 * --- | 1,2,5 | H 04 N   7/13 G 06 F  15/76 |
| A | ICASSP'85 PROCEEDINGS, Tampa, Florida, 26-29 mars 1985, vol. 1, pages 339-342, IEEE, New York, US; H.F. SUN et al.: "Adaptive vector quantization for image sequence coding" * Page 340, colonne de droite, ligne 59 - page 341, colonne de gauche, ligne 45; figures 1-3 * --- | 1,5 | |
| A | EP-A-0 037 164  (NESTOR ASSOCIATES) * Page 3, lignes 1-18; page 5, ligne 10 - page 6, ligne 2 * --- | 1,5 | **DOMAINES TECHNIQUES RECHERCHES (Int. Cl.5)** |
| A | NEURAL NETWORKS, no. 1, supplément 1, 1988, page 399; J.J. PAULOS et al.: "A VLSI architecture for feedforward networks with integral back-propagation" * En entier * ----- | 1,5 | H 04 N H 03 M G 06 K G 06 F |

Le présent rapport a été établi pour toutes les revendications

| Lieu de la recherche | Date d'achèvement de la recherche | Examinateur |
|---|---|---|
| LA HAYE | 19-02-1990 | BOSCH F.M.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
......................................................................
& : membre de la même famille, document correspondant